Europäisches Patentamt

European Patent Office

Office européen des brevets

(11) Publication number: **0 164 095**
A2

# EUROPEAN PATENT APPLICATION

(21) Application number: 85106857.7

(22) Date of filing: 04.06.85

(51) Int. Cl.⁴: **H 01 L 29/78, H 01 L 29/10**

(30) Priority: 08.06.84 US 618443

(43) Date of publication of application: 11.12.85
Bulletin 85/50

(84) Designated Contracting States: **DE FR GB NL**

(71) Applicant: **EATON CORPORATION, Eaton
Center 111 Superior Ave., Cleveland Ohio 44114 (US)**

(72) Inventor: **Benjamin, James Anthony, 20865 Hawthorne
Ridge Court, Waukesha Wisconsin 53186 (US)**
Inventor: **Lade, Robert Walter, 1009 North Jackson
Street Apartment 2302, Milwaukee Wisconsin 43202 (US)**
Inventor: **Schutten, Herman Peter, 8545 North Fielding
Road, Bayside Wisconsin 53217 (US)**

(74) Representative: **Wagner, Karl H., WAGNER & GEYER
Patentanwälte Gewuerzmuehlstrasse 5 Postfach 246,
D-8000 München 22 (DE)**

(54) Vertical bidirectional stacked power fet.

(57) A vertical bidirectional multi-channel stacked power FET (40) has a plurality of alternating conductivity type layers extending laterally horizontally and stack vertically between top and bottom major surfaces (44, 46). The stack (48) includes a plurality of channel-containing regions (49-54) interleaved with a plurality of source regions (55-61). A notch (70) extends downwardly through the lowermost channel-containing region of the stack and includes an insulated gate electrode (68) for inverting the conductivity type of the channel-containing regions to induce conduction channels (49a–54a) between the source regions and enable bidirectional field effect current conduction between the top and bottom surfaces. OFF state voltage is dropped in each direction serially across the junctions between the layers such that depletion region spreading from a plurality of junctions must be vertically coupled before OFF state breakdown.

EP 0 164 095 A2

# VERTICAL BIDIRECTIONAL STACKED POWER FET

## Background and Summary

The invention relates to power switching semiconductors, and more particularly to power MOSFETs (metal oxide semiconductor field effect transistors), and the like.

The present invention provides a vertical bidirectional multi-channel stacked power FET. A plurality of alternating conductivity type layers extend laterally horizontally, and are stacked vertically between top and bottom major surfaces, and include a plurality of channel-containing regions interleaved with a plurality of source regions. Gate means is provided for inverting the conductivity type of the channel-containing regions to induce conduction channels between the source regions and enable bidirectional field effect current conduction vertically serially through the layers.

In the OFF state, voltage is serially dropped across the junctions between the stacked layers. The set of junctions between the channel-containing regions and respective contiguous source regions therebelow blocks one direction of current flow. The alternate set of junctions between the channel-containing regions and its contiguous source regions thereabove blocks the opposite direction current flow. Depletion region spreading from the plurality of junctions must be vertically coupled before breakdown, whereby to enhance bidirectional voltage blocking capability in the OFF state.

## Brief Description Of The Drawings

### Prior Art

FIG. 1 is a schematic sectional view of a UMOS FET.

### Present Invention

FIG. 2 is a schematic sectional view illustrating vertical bidirectional FET structure in accordance with the invention.

FIG. 3 is a view like FIG. 2 showing a gating arrangement.

## Description Of Prior Art

MOSFETs can generally be classified into two groupings according to the principal orientation of current flow, namely vertical and lateral. For the vertical unit, there are two predominant geometries: planar (HEXFET, TMOS, SIPMOS, etc.); and non-planar (VMOS, UMOS, etc.). The advantage that these devices enjoy over their lateral or horizontal counterparts is that the drain contact is placed on the bottom of the chip. Thus, for a given chip area, higher current ratings (higher packing densities) are possible.

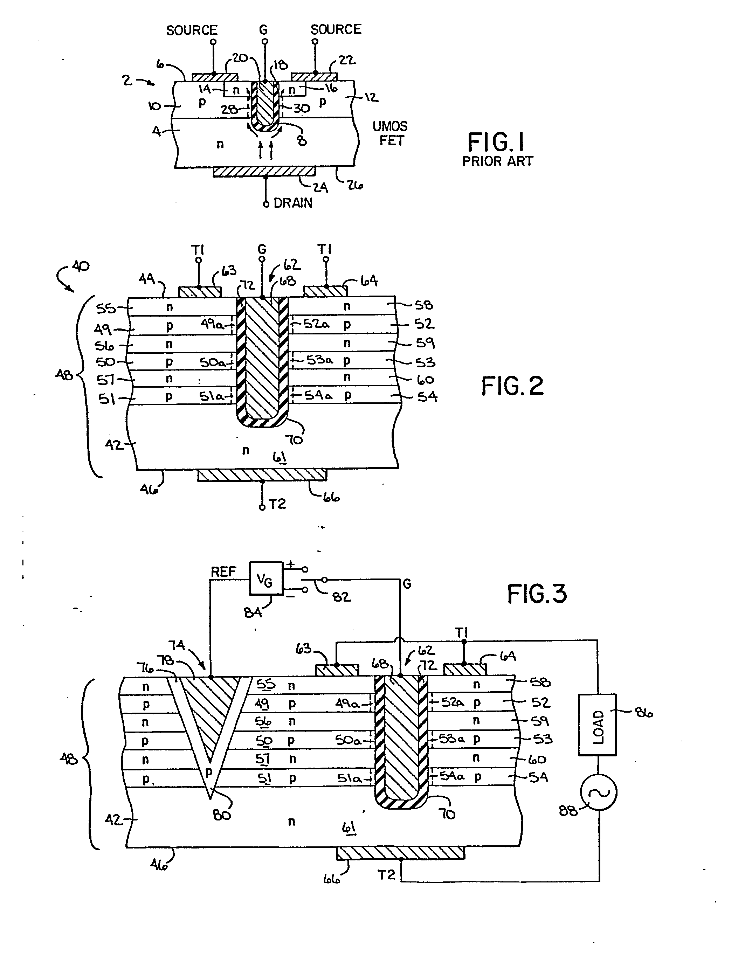

A cross sectional view of a typical non-planar vertical device is illustrated in FIG. 1, showing a UMOS structure 2. Starting with an n type silicon substrate 4, successive p and n diffusions are carried out, followed by anisotropic etching of a groove or notch downwardly from top major surface 6 into region 4, forming notch 8 separating p type channel-containing regions 10 and 12 and n type source regions 14 and 16. An insulating oxide layer 18 is formed in notch 8, followed by deposition of gate metalization 20. Source metalization 20 and 22 is deposited on top major surface 6, and drain electrode metalization 24 is deposited on the bottom major surface 26.

FET channels 28 and 30 are through p regions 10 and 12 along the sides of notch 8. Upon application of a positive voltage on gate electrode G relative to source electrodes 20 and 22, electrons in p regions 10 and 12 are attracted into channels 28 and 30 to invert the conductivity type of the channels to n type. Electrons may then flow from source regions 14 and 16 through channels 28 and 30 to drain region 4; and hence current may flow from drain electrode 24 through drain 4 through channels 28 and 30 through source regions 14 and 16 to source electrodes 20 and 22.

## Detailed Description Of The Invention

There is shown in FIG. 2 a vertical bidirectional multi-channel stacked power FET 40 in accordance with the invention. Semiconductor body 42 has top and bottom major surfaces 44 and 46. A plurality of alternating conductivity type layers extend laterally horizontally and are stacked vertically between the top and bottom surfaces. Stack 48 includes a plurality of channel-containing regions 49-54 interleaved with a plurality of source regions 55-61. Gate means 62 is provided for inverting the conductivity type of channel-containing regions 49-54 to induce conduction channels 49a-54a between the source regions and enable bidirectional field effect current conduction between top and bottom surfaces 44 and 46.

The layers are stacked between top source regions 55 and 58 at top major surface 44 and bottom source region 61 at bottom major surface 46. A top main terminal T1 contacts the top source regions 55 and 58 by metalizations 63 and 64 along top major surface 44. A bottom main terminal T2 contacts bottom source region 61 by metalization 66 along bottom major surface 46. The current conduction path between main terminals T1 and T2 traverses serially through the plurality of stacked layers 48.

Source regions 55-61 are of one conductivity type, such as n type. Channel-containing regions 49-54 are of opposite conductivity type, such as p type. Gate means 62 includes a gate electrode 68 proximate channel-containing regions 49-54 for applying an electric field to invert the conductivity thereof to n type to enable bidirectional current flow serially through the plurality of n type conduction channels 49a-54a interleaved with the plurality of n type source regions 55-61.

A notch 70 is anisotropically etched in body 42 and extends from top major surface 44 downwardly into bottom source region 61, and laterally separates stacked layers 48 into left and right portions. Top main terminal T1 has left and right main electrodes 63 and 64 respectively contacting left and right top source regions 55 and 58 on left and right sides of notch 70 along top major surface 44. Gate 62 includes a layer of dielectric insulation 72 along the inner surface of notch 70. Gate electrode 68 is disposed in the notch along insulation layer 72. The current path between main terminals T2 and T1 traverses generally vertically through bottom source region 61 below notch 70 and traverses along the left and right sides of notch 70 through the left and right stacks including the plurality of conduction channels 49a-51a and 52a-54a vertically stacked on each side of notch 70.

FET 40 has an OFF state in the absence of the noted gating electric field on terminal G. The set of junctions between the channel-containing regions and respective contiguous source regions therebelow blocks one direction of current flow, namely upward current flow. The alternate set of junctions between the channel-containing regions and respective contiguous source regions thereabove blocks the opposite direction current flow, namely downward current flow. OFF state voltage between the main terminals is dropped in each direction across the respective set of junctions in series such that depletion region spreading from the plurality of junctions must be vertically coupled before breakdown, whereby to enhance bidirectional voltage blocking capability in the OFF state.

FIG. 3 shows a preferred gate referencing arrangement, and like reference numerals are used from FIG. 2 where appropriate to facilitate understanding. Dedicated gate reference terminal 74 is connected to the p type channel-containing regions in stack 48. Gate reference terminal 74 includes a p type gate reference layer 76 extending across and contacting the layers of stack 48, and a reference gate electrode 78 contacting p layer 76. A gate reference groove or notch 80 is anisotropically etched vertically into stack 48. P type reference gate layer 76 extends along the inner surface of groove 80 to contact the layers of stack 48.

Gate electrode 68 is connected through gate terminal G and switch 82 to a source of gate biasing potential 84 which is referenced to gate reference terminal 74. With switch 82 in its upward position, electrode 68 is positive relative to electrode 78 and a potential field is applied across the channel-containing regions such that electrons are attracted toward notch 70 to invert the conductivity type of channels 49a-54a to n type and thus induce n type conduction channels vertically between the source regions. In this ON state, current can flow bidirectionally between main terminals T2 and T1, which are connected in an AC load line including load 86 and AC source 88. During the first half cycle, with T1 positive with respect to T2, current flows from electrodes 63 and 64 downwardly through left and right top source regions 55 and 58, then downwardly through vertical conduction channels 49a and 52a along the left and right sides of notch 70, then downwardly through left and right source regions 56 and 59, then downwardly through left and right conduction channels 50a and 53a, then downwardly through left and right source regions 57 and 60, then downwardly through left and right conduction channels 51a and 54a, then downwardly through bottom source region 61 to bottom electrode 66. During the second half cycle, with T2 positive with respect to T1, current flows along the same path, but upwardly in the opposite direction.

In the OFF state, switch 82 is in its central position, or is in its downward position to apply a negative potential on gate electrode 68 relative to reference electrode 78. This negative bias prevents attraction of electrons toward notch 70 in the OFF state to thus prevent unwanted inducement of conduction channels at 49a-54a.

It is recognized that various modifications are possible within the scope of the appended claims.

CLAIMS

1. A vertical bidirectional multi-channel stacked power FET comprising a semiconductor body having top and bottom major surfaces and a plurality of alternating conductivity type layers extending laterally horizontally and stacked vertically between said top and said bottom surfaces, said stack comprising a plurality of channel-containing regions interleaved with a plurality of source regions, and gate means for inverting the conductivity type of said channel-containing regions to induce conduction channels between said source regions and enable bidirectional field effect current conduction between said top and bottom surfaces.

2. The invention according to claim 1 wherein said layers are stacked between a top source region at said top major surface and a bottom source region at said bottom major surface, and comprising a top main terminal contacting said top source region along said top major surface, and a bottom main terminal contacting said bottom source region along said bottom major surface, the current conduction path between said main terminals traversing serially through said plurality of stacked layers.

3. The invention according to claim 2 wherein:

said source regions are of one conductivity type semiconductor material;

said channel-containing regions are of opposite conductivity type semiconductor material;

and said gate means comprises gate electrode means proximate said channel-containing regions for applying an electric field to invert the conductivity thereof to said one conductivity type to enable bidirectional current flow serially through a plurality of conduction channels of said one conductivity type interleaved with said pluralitity of source regions of said one conductivity type.

4. The invention according to claim 3 comprising:

notch means in said semiconductor body extending from said top major surface downwardly into said bottom source region and laterally separating said stacked layers into left and right portions;

and wherein:

said top main terminal has left and right main electrodes respectively contacting left and right top source regions on left and right sides of said notch means along said top major surface;

said gate means comprises a layer of insulation along the inner surface of said notch means;

said gate electrode means is disposed in said notch means along said insulation layer;

said current path between said main terminals traverses generally vertically through said bottom source region below said notch means and traverses along the left and right sides of said notch means through the left and right stacks including the plurality of conduction channels vertically stacked on each side of said notch means.

5. The invention according to claim 4 wherein said FET has an OFF state in the absence of said gating electric field, with the set of junctions between the said channel-containing regions and respective contiguous source regions therebelow blocking one direction of current flow, and with the alternate set of junctions between said channel-containing regions and respective contiguous source regions thereabove blocking the opposite direction current flow, OFF state voltage between said main terminals being dropped in each direction across the respective set of junctions in series such that depletion region spreading from a plurality of junctions must be vertically coupled before breakdown, whereby to enhance bidirectional voltage blocking capability in said OFF state.

6. The invention according to claim 5 comprising dedicated gate reference terminal means connected to said channel-containing regions of said opposite conductivity type in said stack.

7. The invention according to claim 6 wherein said gate reference terminal means comprises a gate reference layer of semiconductor material of said opposite conductivity type extending across and contacting said layers of said stack, and a reference gate electrode contacting said reference gate layer.

8. The invention according to claim 7 comprising a gate reference groove notched vertically into said stack, and wherein said reference gate layer of semiconductor material of said opposite conductivity type extends along the inner surface of said gate reference groove to contact said layers of said stack, and said reference gate electrode contacts said reference gate layer.

1/1

FIG.1
PRIOR ART

FIG.2

FIG.3